(19) **Europäisches Patentamt / European Patent Office / Office européen des brevets**

(11) **EP 3 050 127 B1**

(12) # FASCICULE DE BREVET EUROPEEN

(45) Date de publication et mention de la délivrance du brevet:
**15.11.2017  Bulletin 2017/46**

(51) Int Cl.:
**H01L 31/18** *(2006.01)*  **C30B 1/02** *(2006.01)*

(21) Numéro de dépôt: **14789403.4**

(22) Date de dépôt: **24.09.2014**

(86) Numéro de dépôt international:
**PCT/IB2014/064796**

(87) Numéro de publication internationale:
**WO 2015/044875 (02.04.2015 Gazette 2015/13)**

(54) **PROCEDE DE PREPARATION D'UN SUBSTRAT DE SILICIUM RECRISTALLISE A GROS CRISTALLITES**

VERFAHREN ZUR HERSTELLUNG EINER REKRISTALLISIERTEN SILICIUMSUBSTRATS MIT GROSSEN KRISTALLITEN

METHOD FOR PREPARING A RECRYSTALLISED SILICON SUBSTRATE WITH LARGE CRYSTALLITES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.09.2013  FR 1359341**

(43) Date de publication de la demande:
**03.08.2016  Bulletin 2016/31**

(73) Titulaire: **Commissariat à l'Energie Atomique et aux Energies Alternatives
75015 Paris (FR)**

(72) Inventeurs:
- **LEBRUN, Jean-Marie
  Malborough, MA 01752 (US)**
- **GARANDET, Jean-Paul
  92210 Saint-Cloud (FR)**
- **MISSIAEN, Jean-Michel
  38400 Saint Martin D'heres (FR)**
- **PASCAL, Céline
  38410 Saint Martin D'uriage (FR)**

(74) Mandataire: **Nony
11 rue Saint-Georges
75009 Paris (FR)**

(56) Documents cités:
**WO-A1-2004/093202    WO-A1-2012/049300**

- **SCHINS W J H ET AL: "Deformation and recrystallization of polycrystalline silicon", JOURNAL OF MATERIALS SCIENCE, KLUWER ACADEMIC PUBLISHERS, DORDRECHT, vol. 16, no. 11, 1 novembre 1981 (1981-11-01), pages 3153-3160, XP008169550, ISSN: 0022-2461, DOI: 10.1007/BF00540324 cité dans la demande**
- **LALL C ET AL: "Recrystallization of polycrystalline silicon", MATERIALS SCIENCE ENGINEERING, ELSEVIER SEQUOIA, LAUSANNE, CH, vol. 47, no. 3, 1 mars 1981 (1981-03-01), pages 265-270, XP024086438, ISSN: 0025-5416, DOI: 10.1016/0025-5416(81)90052-5 [extrait le 1981-03-01]**
- **KINOSHITA M ET AL: "Recrystallization of cast polycrystalline silicon", MATERIALS SCIENCE ENGINEERING, ELSEVIER SEQUOIA, LAUSANNE, CH, vol. 47, no. 1, 1 janvier 1981 (1981-01-01), pages 29-35, XP024085783, ISSN: 0025-5416, DOI: 10.1016/0025-5416(81)90037-9 [extrait le 1981-01-01]**
- **JEAN-MARIE LEBRUN ET AL: "The Role of Silica Layer on Sintering Kinetics of Silicon Powder Compact", JOURNAL OF THE AMERICAN CERAMIC SOCIETY, vol. 95, no. 5, 16 janvier 2012 (2012-01-16), pages 1514-1523, XP055119572, ISSN: 0002-7820, DOI: 10.1111/j.1551-2916.2011.05052.x cité dans la demande**

- **REBER S ET AL: "Crystalline silicon thin-film solar cells-recent results at Fraunhofer ISE", SOLAR ENERGY, PERGAMON PRESS. OXFORD, GB, vol. 77, no. 6, 1 décembre 2004 (2004-12-01), pages 865-875, XP004661827, ISSN: 0038-092X, DOI: 10.1016/J.SOLENER.2004.08.021 cité dans la demande**

**Description**

La présente invention se rapporte à un nouveau procédé de préparation d'un substrat de silicium, présentant une taille moyenne de cristallites supérieure ou égale à 20 μm, à partir d'un substrat de silicium polycristallin à grains de trop petite taille pour être utilisé directement pour des applications photovoltaïques.

Le silicium cristallisé sous la forme de cristallites de taille supérieure à 20 μm est en effet particulièrement intéressant pour ses propriétés semi-conductrices dans le cadre de l'élaboration des cellules photovoltaïques.

Actuellement, les cellules photovoltaïques sont majoritairement fabriquées à partir de silicium monocristallin ou multicristallin. La filière de production de silicium cristallin la plus courante met en jeu la solidification directionnelle de lingots à partir d'un bain de silicium liquide. Ces lingots sont ensuite découpés en plaquettes qui peuvent être transformées en cellules photovoltaïques. Malheureusement, le sciage des lingots entraîne une perte de matière en silicium (« kerf loss ») de l'ordre de 50 %. Pour des raisons évidentes, cette perte de matière liée au sciage est préjudiciable aux rendements de production.

Comme alternatives à la fabrication de plaquettes par sciage de lingots, des techniques ont été développées en vue d'élaborer directement le silicium sous forme de plaquettes ou de rubans d'épaisseur typique variant entre 100 et 500 μm (Edge-defined Film-fed Growth, Ribbon Against Drop et Ribbon Growth on Substrate). Cependant, ces méthodes ne donnent pas totalement satisfaction, notamment au regard des problèmes de coût et/ou de contrôle de procédé qu'elles soulèvent.

Une autre option pour s'affranchir du problème de perte de matière en silicium est de mettre en oeuvre des techniques d'épitaxie en phase liquide (LPE ou en langue anglaise « Liquid Phase Epitaxy ») ou gazeuse (VPE ou en langue anglaise « Vapour Phase Epitaxy »). Ces techniques permettent d'obtenir, par croissance sur un substrat, des couches de plusieurs dizaines de micromètres d'épaisseur et de bonne qualité cristalline, avec un coût modéré et des vitesses de croissance élevées (typiquement de 0,1 à 5 μm/min).

Malheureusement, les méthodes conventionnelles d'épitaxie imposent, pour obtenir des couches de qualité suffisante, de mettre en oeuvre des substrats monocristallins coûteux.

Or, dans un souci de réduction des coûts, il est primordial de s'affranchir de l'usage de substrats de silicium monocristallin, au profit de substrats de silicium polycristallin, dits substrats à « bas coût ».

Pour la réalisation de tels substrats en silicium polycristallin, deux techniques, basées sur le frittage de poudres de silicium, ont été récemment proposées. La première est basée sur un pressage à chaud d'un lit de poudres dans un moule [1] ; la seconde sur un frittage thermique sans pressage, dit naturel [2]. Toutefois, pour permettre un frittage efficace, la taille des cristallites de départ doit être submicronique, et la maturation au cours du procédé ne permet pas d'obtenir des grains de taille supérieure à 2 μm, même après plusieurs heures à 1 350 °C [3]. Des tailles aussi faibles sont rédhibitoires pour la mise en oeuvre de ces substrats pour des applications photovoltaïques.

Pour suppléer à ce défaut, et obtenir des substrats présentant une taille de grains plus élevée, compatible avec une utilisation photovoltaïque, divers procédés de recristallisation de grains en phase liquide ont été proposés. Par exemple, Reber *et al.* [4] proposent un procédé, dit « ZMR » (pour « Zone Melting Recrystallization » en langue anglaise), consistant à chauffer la surface d'une plaquette frittée par lampes Infra Rouge ou par rayonnement Laser, pour fondre en surface le silicium sur une épaisseur de l'ordre de 10 à 20 μm, le silicium liquide recristallisant ensuite sous forme de grains de taille millimétrique au refroidissement. Cependant, la technique ZMR pose des problèmes de cadence et de contamination de par l'utilisation de très hautes températures nécessaires à la fusion du silicium.

Concernant les procédés de recristallisation en phase solide, la technique utilisant l'association d'une étape de déformation à chaud et d'un traitement thermique de recristallisation est connue dans le domaine de la métallurgie. Cette technique a été mise en oeuvre dans le cas du silicium [5], où elle a permis d'obtenir des cristallites de taille compatible avec les applications photovoltaïques. Cependant, les temps nécessaires pour la recristallisation du silicium sont très importants, supérieurs à une dizaine d'heures, même pour un traitement thermique de recristallisation opéré à une température élevée de l'ordre de 1 300 °C. De telles cinétiques sont incompatibles avec les exigences de rendement de production de l'industrie photovoltaïque.

Par conséquent, il demeure un besoin de disposer d'une méthode, peu coûteuse et à haute productivité, de réalisation d'un substrat de silicium polycristallin à gros cristallites, adapté à l'épitaxie de couches minces de silicium pour une utilisation photovoltaïque.

La présente invention vise précisément à répondre à ce besoin.

Elle concerne ainsi un procédé de préparation d'un substrat de silicium présentant une taille moyenne de cristallites supérieure ou égale à 20 μm, comprenant au moins les étapes consistant en :

(i) disposer d'un substrat de silicium polycristallin dont la taille moyenne des grains est inférieure ou égale à 10 μm ;
(ii) soumettre ledit substrat à une déformation plastique globale et homogène, à une température d'au moins 1 000 °C ;
(iii) soumettre ledit substrat à une déformation plastique localisée en plusieurs zones (3) du substrat, dites zones de sollicitation externe, l'espacement *e* entre deux zones (3) consécutives étant d'au moins 20 μm, la déformation locale étant strictement supérieure à la déformation globale opérée en étape (ii) ;

l'étape (iii) pouvant être réalisée consécutivement ou simultanément à l'étape (ii) ; et

(iv) soumettre le substrat obtenu à l'issue de l'étape (iii) à un traitement thermique de recristallisation en phase solide, à une température strictement supérieure à la température mise en oeuvre en étape (ii), pour obtenir ledit substrat attendu.

De manière surprenante, les inventeurs ont découvert qu'il est possible, en associant une étape (ii) de déformation plastique globale à chaud et une étape (iii) de déformation localisée, d'accéder au substrat à gros cristallites souhaité, avec une durée du traitement de recristallisation réduite. En revanche, chacune des deux étapes (ii) et (iii) de déformation plastique, considérée isolément, ne permet pas, à elle seule, de réaliser la recristallisation souhaitée à une cadence compatible avec les applications photovoltaïques.

Dans la suite du texte, on désignera plus simplement le substrat de silicium obtenu à l'issue de l'étape (iv) du procédé de l'invention, par « substrat recristallisé ». Un substrat de silicium présentant une taille moyenne de cristallites supérieure ou égale à 20 μm, est susceptible d'être obtenu par le procédé défini précédemment.

Un tel substrat recristallisé présente notamment, au niveau d'au moins l'une de ses faces, une succession de reliefs creux, espacés les uns des autres d'une distance (d) dans un plan vertical de coupe, supérieure ou égale à 20 μm, la profondeur d'un relief, mesurée selon une direction parallèle à l'épaisseur du substrat, étant d'au moins 5 μm, en particulier 20 à 100 μm. Un dispositif photovoltaïque, en particulier une cellule photovoltaïque, comportant un substrat de silicium tel que défini précédemment est susceptible d'être obtenu. D'autres caractéristiques, avantages et modes d'application du procédé selon l'invention ressortiront mieux à la lecture de la description détaillée qui va suivre, des exemples de réalisation et à l'examen des dessins annexés sur lesquels :

- la figure 1 représente, de manière schématique et en coupe transversale, les différentes étapes du procédé de préparation d'un substrat de silicium recristallisé selon l'invention, selon un mode de réalisation particulier illustré en exemple 1 ;
- la figure 2 représente, de manière schématique et en coupe transversale, la structure du substrat de silicium recristallisé à l'issue de l'étape (iv) du procédé de l'invention (substrat recristallisé (10) représenté dans sa totalité, et zoom de la structure du substrat au niveau d'un relief creux (4)).

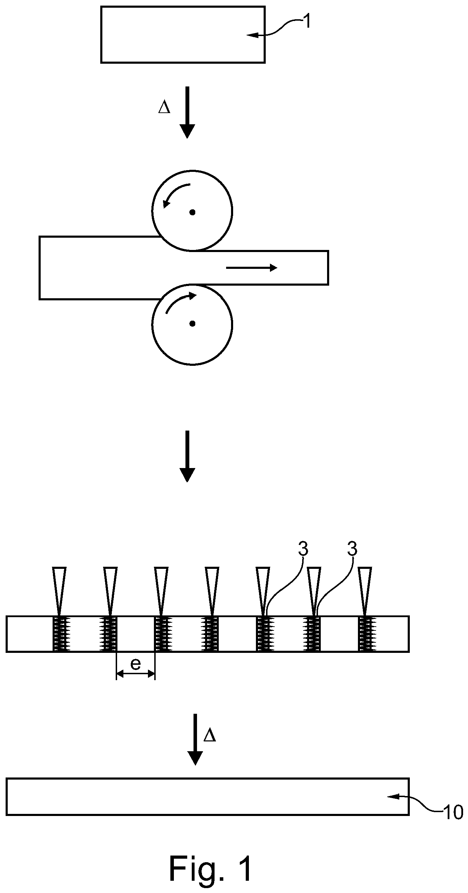

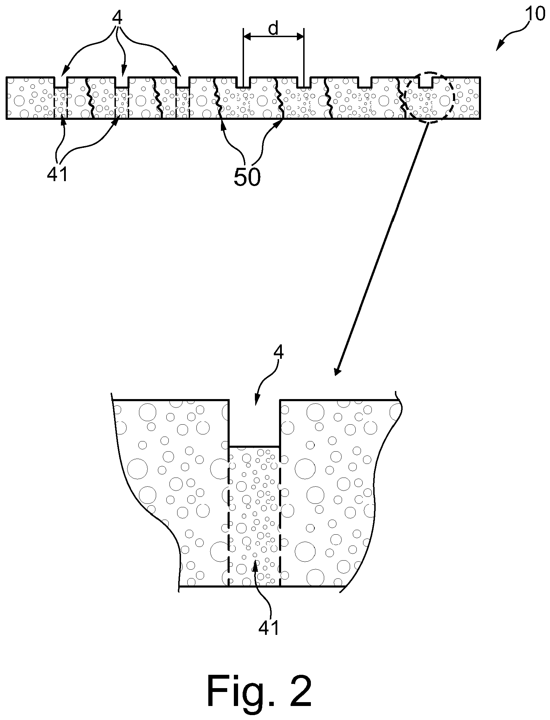

Il convient de noter que, pour des raisons de clarté, les différents éléments sur les figures 1 et 2 sont représentés en échelle libre, les dimensions réelles des différentes parties n'étant pas respectées.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, les expressions « comportant/comprenant un(e) » et « définissant un(e) » doivent être comprise comme « comportant/comprenant au moins un(e) » et « définissant au moins un(e) ».

## ETAPE (i) : SUBSTRAT DE SILICIUM POLYCRISTALLIN

Comme évoqué précédemment, le procédé de l'invention met en oeuvre un substrat de silicium polycristallin présentant une taille moyenne de grains inférieure ou égale à 10 μm, désigné dans la suite du texte comme « substrat de départ ».

Dans le cadre de la présente invention, le terme « substrat » fait référence à une structure de base solide, présentant au moins deux faces sensiblement parallèles. Le substrat mis en oeuvre dans le procédé de l'invention peut se présenter plus particulièrement sous la forme d'une plaquette. Il peut notamment être de forme pavé droit, de base carrée ou rectangulaire.

Dans la suite du texte, et sauf indication contraire, le substrat de type plaquette est caractérisé lorsqu'il est observé dans sa position horizontale (c'est-à-dire selon une direction normale à la direction de la gravité terrestre, dite direction verticale).

De préférence, les dimensions du substrat de départ sont choisies de manière à ce que le substrat recristallisé obtenu à l'issue du procédé de l'invention présente les dimensions souhaitées, en particulier des dimensions appropriées à des applications photovoltaïques.

Le substrat de départ mis en oeuvre en étape (i) du procédé de l'invention peut par exemple présenter, dans un plan vertical de coupe, une largeur comprise entre 5 et 25 cm. La longueur du substrat de départ peut être supérieure ou égale à la largeur, en particulier comprise entre 1 fois et 5 fois sa largeur.

Il peut présenter une épaisseur supérieure ou égale à 100 μm, en particulier comprise entre 100 et 1 000 μm, et plus particulièrement comprise entre 200 et 500 μm.

Selon un mode de réalisation particulier, le substrat de silicium de départ présente une taille moyenne de grains inférieure ou égale à 5 μm, en particulier comprise entre 0,1 et 2 μm.

La taille moyenne des grains peut être déterminée par microscopie électronique à balayage (MEB) et analyse d'image, celle-ci permettant de déterminer la surface des grains observés, la taille moyenne des grains correspondant alors à la racine carrée d'une telle surface.

Un tel substrat de silicium peut être par exemple élaboré, préalablement à sa mise en oeuvre en étape (i) du procédé de l'invention, par frittage, notamment à partir d'une poudre de particules de silicium ou d'une préforme obtenue par compaction d'une poudre de particules de silicium.

Il relève des connaissances générales de l'homme du métier d'adapter la technique et les conditions du frittage, par exemple en termes de caractéristique granulométrique de la poudre de silicium utilisée, pour obtenir le substrat de silicium polycristallin de départ souhaité.

Le frittage peut être par exemple opéré avec charge ou sans charge, la charge consistant à appliquer une force extérieure sur l'échantillon, lors du traitement thermique, afin d'en favoriser la densification.

Selon un mode de réalisation particulièrement préféré, le substrat de départ est élaboré par une technique de frittage naturel, autrement dit sans charge. Une telle technique de frittage naturel permet avantageusement de s'affranchir des problèmes de contamination liés à la charge, et d'obtenir un substrat de bonne pureté, compatible avec des applications photovoltaïques.

A titre d'exemple, le substrat de silicium mis en oeuvre en étape (i) du procédé de l'invention peut être élaboré suivant la technique de frittage proposée dans le document WO 2012/049300 [2], cette technique permettant avantageusement d'accéder à un substrat de densité et de porosité contrôlées.

Le substrat de départ peut par exemple présenter une porosité inférieure ou égale à 40 %, en particulier comprise entre 0 et 20 %. La porosité peut être mesurée par la méthode de densité Archimède.

## ETAPE (ii): DEFORMATION PLASTIQUE GLOBALE ET HOMOGENE

Selon une seconde étape (ii) du procédé de l'invention, le substrat de départ est soumis à une première étape de déformation plastique, globale et homogène, opérée à chaud.

Par l'expression «soumettre le substrat à une déformation », on entend désigner le fait d'appliquer une sollicitation externe sur au moins une partie du substrat, de façon à ce que la distance entre deux points dudit substrat soit modifiée, d'une manière réversible et/ou irréversible. La sollicitation externe consiste classiquement en l'application d'un déplacement, par exemple par contact d'au moins une face du substrat avec un dispositif adapté, par exemple un laminoir, un banc de traction ou un banc de compression. Elle peut encore s'effectuer par exposition du substrat à déformer à un rayonnement, par exemple un rayonnement laser.

La déformation du substrat de silicium, résultant d'une étape de déformation, comporte une composante de déformation réversible, dite élastique, et une composante de déformation irréversible, dite plastique. Dans le cadre des déformations imposées au substrat selon le procédé de l'invention, la composante élastique étant très faible, voire négligeable, au regard de la composante plastique, les déformations appliquées selon le procédé de l'invention peuvent être considérées comme des déformations plastiques.

On entend par « globale », le fait que la déformation plastique en étape (ii) est produite dans au moins 95 % du volume du substrat, en particulier au moins 99 % du volume du substrat.

Par « homogène », on entend désigner le fait que la déformation plastique du substrat produite en étape (ii) est sensiblement constante sur le volume du substrat déformé.

Autrement dit, une étape de déformation du substrat, dite « globale et homogène », est telle que la modélisation analytique ou numérique, par exemple réalisée à l'aide du logiciel de calcul CASTEM, du comportement mécanique du substrat au cours de ladite étape de déformation, résulte en un champ de déformation homogène.

L'étape de déformation globale (ii) peut être plus particulièrement opérée à l'aide d'une sollicitation externe consistant en l'application de déplacements sur au moins une face du substrat, de préférence sur au moins 80 %, en particulier au moins 90 %, voire sur la totalité de l'aire de ladite face du substrat.

Une telle déformation globale du substrat peut être produite par exemple par une opération de laminage, comme détaillé plus particulièrement dans la suite du texte : l'épaisseur du substrat de silicium de départ est alors réduite, sa largeur (mesurée dans une direction parallèle à l'axe de rotation des rouleaux de laminage) est conservée, et sa longueur augmentée.

L'homogénéité de la déformation du substrat à l'issue de l'étape (ii) du procédé de l'invention peut être par exemple vérifiée *via* une mesure locale des déformations, par exemple à travers la mesure par une technique laser des variations des dimensions géométriques de l'échantillon, ou à l'aide d'une mesure des champs de déplacements des plans atomiques par diffraction des rayons X. Les techniques laser de mesure des variations des dimensions géométriques de l'échantillon et de topographie aux rayons X sont connues de l'homme de l'art.

L'étape (ii) de déformation plastique globale du substrat selon le procédé de l'invention est opérée à chaud, à une température d'au moins 1 000 °C.

De préférence, elle est opérée à une température inférieure ou égale à 1 200 °C, en particulier comprise entre 1 100 et 1 200 °C, et plus particulièrement d'environ 1 150 °C. Plus particulièrement, par « étape opérée à une température X», on entend une étape opérée dans un four dont la température de fonctionnement est fixée à une valeur de consigne X.

Dans le domaine de la mise en forme des métaux, l'homme du métier est à même de mettre en oeuvre des techniques adéquates pour induire une déformation globale et homogène du substrat.

L'étape (ii) de déformation du substrat peut être par exemple opérée par compression simple, compression plane (ou « Channel die compression » en langue anglaise) encore appelée cisaillement pur, par compression biaxiale, par traction simple, par traction biaxiale, par cisaillement simple, par laminage (« rolling » en langue anglaise). Parmi ces techniques, le laminage, de par sa simplicité de mise en oeuvre, est particulièrement préféré.

Selon un mode de réalisation particulièrement préféré, l'étape (ii) selon l'invention est ainsi opérée par laminage à chaud.

Comme représenté schématiquement en figure 1, le laminage peut être conduit en introduisant complètement le substrat (1) de l'étape (i) entre les deux rouleaux de laminage d'un laminoir, pour réduire l'épaisseur du substrat. Un passage du substrat entre les rouleaux de laminage constitue une étape de déformation, dite « passe de laminage ». L'étape (ii) de déformation globale peut comporter une unique ou plusieurs passes de laminage. Dans le cas où plusieurs passes de laminage sont opérées, la déformation plastique totale appliquée est calculée au regard de l'épaisseur du substrat (1) de départ avant la première passe de laminage et de son épaisseur après la dernière passe de laminage.

De préférence, le laminage à chaud est mis en oeuvre à l'aide de rouleaux de laminage en nitrure de silicium ($Si_3N_4$) ou en carbure de silicium (SiC). Le carbure de silicium comportant moins d'impuretés, des rouleaux en carbure de silicium sont préférentiellement utilisés. Les risques de pollution du substrat de silicium, au contact de la surface des rouleaux de laminage, sont ainsi avantageusement limités.

Le substrat obtenu à l'issue de l'étape (ii) de l'invention est désigné, dans la suite du texte, comme « substrat globalement déformé ».

Ce substrat globalement déformé présente des défauts cristallins, notamment sous la forme de dislocations et de macles, répartis de façon sensiblement homogène dans le volume du substrat lorsqu'observé à une échelle d'observation supérieure à 1 mm.

Selon un mode de réalisation particulier, le substrat globalement déformé à l'issue de l'étape (ii) du procédé de l'invention présente une déformation plastique homogène comprise entre 1 et 20 %, en particulier entre 5 et 10 %, et plus particulièrement entre 5 et 9 %.

Le taux de déformation plastique peut être estimé selon des méthodes connues de l'homme du métier en prenant en considération les conditions expérimentales de mise en oeuvre de la déformation, par exemple *via* la mesure des déplacements imposés sur la ou les faces du substrat.

De façon conventionnelle, la déformation peut être mesurée par la quantité $\mathscr{E}^p = 1 - h/h_0$ avec $h_0$ l'épaisseur initiale du substrat en étape (i) avant déformation et h l'épaisseur du substrat globalement déformé à l'issue de l'étape (ii) du procédé de l'invention.

Les dimensions $h_0$ et h peuvent être mesurées par des méthodes classiques, par exemple à l'aide d'une méthode de mesure par laser.

La déformation globale du substrat à l'issue de l'étape (ii) peut être considérée comme homogène lorsque la condition (A) suivante est vérifiée :

$$\sqrt{\frac{1}{n-1}\sum_{i=1}^{n}\left(\varepsilon_i^p - \bar{\varepsilon}^p\right)^2} \leq 0,1\,\bar{\varepsilon}^p \qquad (A)$$

où :

- $\varepsilon_i^p$ représente la déformation plastique, mesurée localement, par exemple par laser, dans une partie du substrat, dite zone de mesure *i*. Les zones de mesures peuvent être sélectionnées au hasard ou réparties de manière régulière à la surface du substrat globalement déformé. La surface de chacune desdites zones de mesure peut être comprise entre 1 $\mu m^2$ et 50 $\mu m^2$, voire entre 2 $\mu m^2$ et 20 $\mu m^2$.

- *n* correspond au nombre de zones de mesure sur lesquelles la mesure est effectuée, de préférence *n* $\geq$ 5, voire *n* $\geq$ 10 ; et

- $\bar{\varepsilon}^p = \frac{\sum_{i=1}^{n} \varepsilon_i^p}{n}$ est la moyenne arithmétique des déformations mesurées sur les *n* zones de mesure du substrat.

## ETAPE (iii): DEFORMATION PLASTIQUE LOCALISEE

Selon une troisième étape (iii) du procédé de l'invention, comme représenté en figure 1, le substrat est soumis à une seconde déformation plastique. A la différence de l'étape (ii) de déformation plastique globale et homogène, cette étape (iii) de déformation est localisée en plusieurs zones prédéfinies (3) du substrat, appelées dans la suite du texte « zones de sollicitation externe ».

Une étape de déformation plastique « localisée » s'entend de l'application d'une sollicitation externe en plusieurs zones (3) déterminées de la surface du substrat, situées au niveau d'au moins l'une des faces du substrat, et affectant essentiellement la partie du substrat localisée en-deçà desdites zones (3), à la différence d'une déformation dite « globale » qui affecte la totalité du substrat. L'aire totale des zones (3) de sollicitation externe au niveau de l'une des faces du substrat représente en particulier moins de 10 % de l'aire de ladite face.

Autrement dit, la modélisation analytique ou numérique, par exemple à l'aide du logiciel de calcul CASTEM appliquant la méthode des éléments finis, du comportement mécanique du substrat au cours de ladite étape (iii) de déformation localisée, résulte en un champ de déformation non-homogène dans le volume du substrat, c'est-à-dire présentant des gradients de déformation.

En d'autres termes, le critère (A) d'homogénéité, défini précédemment pour la déformation globale et homogène, n'est en aucun cas vérifié pour le substrat déformé obtenu à l'issue de l'étape (iii).

Dans le cas où la sollicitation externe correspond à l'application de déplacements par contact, la zone (3) de sollicitation externe est définie par la surface de la face du substrat sur laquelle les déplacements sont imposés. Dans le cas où la sollicitation externe correspond à l'interaction d'un rayonnement, par exemple laser, avec le silicium, la zone de sollicitation externe correspond à la surface définie par l'intersection du faisceau émis par la source de rayonnement avec la face du substrat qu'il rencontre.

Selon une des caractéristiques de l'étape (iii) de déformation localisée du procédé de l'invention, l'espacement (e) entre deux zones de sollicitation externe (3) consécutives, mesuré dans un plan vertical de coupe, est d'au moins 20 $\mu$m.

De préférence, deux zones (3) consécutives sont espacées d'une distance e supérieure ou égale à 80 $\mu$m, en particulier supérieure ou égale à 100 $\mu$m, notamment supérieure ou égale à 150 $\mu$m, et de préférence comprise entre 200 et 2 000 $\mu$m.

Selon un mode de réalisation particulièrement préféré, l'étape (iii) de déformation est localisée en des zones (3) régulièrement espacées au niveau de l'une des faces du substrat. Autrement dit, la distance (e) entre deux zones (3) consécutives est sensiblement identique pour l'ensemble des zones (3) du substrat.

En fonction du moyen d'application de la sollicitation externe, les zones (3) peuvent se présenter sous différentes formes, par exemple sous forme d'un carré, d'un disque, d'une ellipse, d'une bande, etc.

De préférence, les zones (3) sont sous forme de bandes ou rayures, parallèles les unes aux autres, s'étendant d'un bord à l'autre du substrat, suivant sa longueur ou sa largeur. Ces bandes ou rayures peuvent notamment présenter une largeur dans un plan vertical de coupe, inférieure à 100 $\mu$m, en particulier comprise entre 2 et 50 $\mu$m.

L'étape (iii) de déformation localisée peut être opérée à diverses températures, en fonction notamment des moyens de mise en oeuvre de la déformation (compression, cisaillement, rayonnement laser, etc.).

Selon une première variante de réalisation particulièrement préférée, l'étape (iii) de déformation localisée est opérée à une température supérieure ou égale à 1 000 °C, notamment comprise entre 1 100 °C et 1 200°C.

Selon un mode de réalisation particulier, elle peut être opérée à une température identique à celle mise en oeuvre pour l'étape (ii) de déformation globale.

Selon une seconde variante de réalisation, l'étape (iii) de déformation localisée est opérée à une température strictement inférieure à 1 000 °C, en particulier comprise entre 400 et 800 °C, et plus particulièrement entre 500 et 800 °C.

Une étape de déformation localisée, opérée à froid, permet avantageusement de générer une densité de défauts cristallins, notamment de dislocations, plus élevée qu'à chaud. L'énergie élastique résiduelle produite par une densité élevée en dislocations est ainsi augmentée, ce qui favorise avantageusement, lors de la recristallisation du substrat en étape (iv), une cinétique de recristallisation accélérée et une faible dispersion en taille des cristallites du substrat final.

Selon un premier mode de réalisation, l'étape (iii) de déformation localisée peut être effectuée au moyen d'une ou plusieurs opérations de compression, par exemple par compression uniaxiale, et/ou d'une ou plusieurs opérations de cisaillement de la surface desdites zones (3), par exemple à l'aide d'une ou plusieurs pointes.

Une opération de compression peut consister à venir comprimer la zone prédéfinie (3) avec la ou lesdites pointes, de sorte que la(les) pointe(s) modifie(nt) localement le relief de la face du substrat d'une manière irréversible. En particulier, la zone du substrat ayant été comprimée présente, à l'issue de l'opération de compression, une forme sensiblement complémentaire de la forme de la pointe d'application de la compression. Lorsqu'aucune opération de cisaillement n'est effectuée consécutivement ou simultanément à une opération de compression, la pointe est déplacée de sorte à être dégagée du substrat sans être translatée au niveau du substrat localement déformé.

Une opération de cisaillement consiste plus particulièrement à mettre la ou lesdites pointes au contact de ladite zone (3), puis à déplacer la ou lesdites pointes selon au moins une direction parallèle à une des faces du substrat, de façon à introduire une déformation de cisaillement.

Selon un mode de réalisation particulièrement préféré, l'étape (iii) de déformation localisée est opérée à l'aide d'un peigne. Un peigne est formé de plusieurs pointes rigides, reliées entre elles par l'intermédiaire d'un support et espacées régulièrement les unes des autres d'une distance (e'), égale à la distance (e) entre deux zones (3) consécutives.

L'application d'une déformation plastique localisée à l'aide d'un peigne permet ainsi de créer dans le substrat un champ de déformation non homogène, présentant la périodicité spatiale souhaitée, dont la période est déterminée par l'espacement entre les pointes du peigne.

Le peigne peut comporter au moins deux, de préférence au moins cinq, en particulier au moins dix pointes.

De préférence, les pointes sont en un matériau plus dur que le silicium, autrement dit en un matériau dont la dureté Vickers est supérieure ou égale à 250 MPa ou de façon équivalente 25.5 Hv par exemple en nitrure de silicium ou en carbure de silicium, de préférence en carbure de silicium.

Selon un premier mode de réalisation particulier, l'étape (iii) de déformation est opérée *via* au moins une étape de compression de la surface desdites zones (3) à l'aide du peigne. Cette étape de compression peut consister à venir comprimer la surface uniaxialement à l'aide du peigne.

Le déplacement de compression, noté *u*, de préférence vertical, imposé au peigne de sorte que les pointes du peigne compriment la surface du substrat à partir de leur position de contact avec les zones (3), peut être plus particulièrement supérieur ou égal à 5 μm, en particulier compris entre 20 et 100 μm.

Le peigne peut encore être translaté afin d'introduire un maximum de cisaillement favorable à la formation de dislocations.

Ainsi, selon un second mode de réalisation particulier, l'étape (iii) de déformation est opérée *via* au moins une opération de translation du peigne à la surface des zones (3), de manière à introduire une déformation de cisaillement.

Bien entendu, les deux modes de réalisation particuliers précités peuvent être combinés, l'étape (iii) de déformation localisée pouvant comprendre à la fois une opération de compression et une opération de cisaillement.

L'homme du métier est à même d'adapter les conditions de mise en oeuvre des étapes de compression et/ou de translation du peigne, de manière à obtenir la déformation locale souhaitée.

Selon une autre variante de réalisation de l'invention, l'étape (iii) de déformation plastique localisée peut être effectuée par exposition desdites zones (3) de sollicitation externe, à un rayonnement, en particulier un rayonnement laser. Un tel traitement laser est classiquement appelé grenaillage laser (« laser shot peening » en langue anglaise).

Le rayonnement laser présente de préférence une ou plusieurs longueurs d'onde supérieures ou égales à 100 nm, notamment allant de 400 à 5 000 nm.

De préférence, le traitement laser est opéré avec un laser de faible taille de spot, par exemple de 1 à 20 μm, préférentiellement de 2 à 5 μm.

Plusieurs sources d'émission du rayonnement laser peuvent être mises en oeuvre, par exemple pour former un peigne de faisceaux régulièrement espacés les uns des autres pour irradier simultanément les différentes zones (3). Alternativement, l'étape (iii) peut être opérée en exposant successivement chacune des zones (3) au rayonnement laser.

Comme évoqué précédemment, la déformation locale du substrat produite en étape (iii) du procédé de l'invention est strictement supérieure à la déformation globale et homogène opérée en étape (ii).

Il est entendu que la « déformation plastique locale du substrat » s'entend de la déformation plastique des parties du substrat localisées en-deçà desdites zones (3) de sollicitation externe.

Selon un mode de réalisation particulier, la déformation plastique locale du substrat (déformation plastique équivalente $\varepsilon^p$), à l'issue de l'étape (iii) du procédé de l'invention, est strictement supérieure à 20 %, en particulier comprise entre 30 et 60 %, et plus particulièrement d'environ 50 %.

Cette déformation plastique correspond à la valeur maximale de déformation du substrat en-deçà de la zone de sollicitation externe. Cette valeur traduit le niveau de déformation subie par le substrat entre son état initial et celui obtenu à l'issue de l'ensemble des déformations appliquées (les déformations s'ajoutent).

Selon une variante de réalisation du procédé de l'invention, les étapes de déformation globale (ii) et de déformation localisée (iii) sont réalisées simultanément sur le substrat de l'étape (i). Elles définissent alors une étape (ii'), dite de déformation conjointe.

Cette étape de déformation conjointe (ii') peut être opérée *via* le passage du substrat entre les deux rouleaux d'un laminoir, de forme générale de cylindre de révolution, au moins l'un des deux rouleaux présentant des bossages s'étendant radialement vers l'extérieur par rapport à l'axe de roulement du rouleau de laminage.

Les bossages peuvent par exemple se présenter sous la forme de portions hémisphériques, de dents, de nervures disposées parallèlement à l'axe du rouleau, de bourrelets annulaires faisant saillie radiale du rouleau, etc. Bien entendu, l'espacement entre deux bossages est choisi de manière adéquate pour l'application de déplacements au niveau des zones localisées (3) du substrat.

De préférence, l'étape (ii') est opérée à l'aide d'un rouleau de laminoir denté.

## ETAPE (iv) : RECRISTALLISATION

Dans une étape (iv) du procédé de l'invention, le substrat, déformé globalement et localement, obtenu à l'issue de l'étape (iii), est soumis à un traitement thermique de recristallisation, dit encore recuit thermique, en phase solide, de façon à obtenir le substrat recristallisé souhaité.

Ce traitement thermique de recristallisation est propice à la germination de cristallites, préférentiellement au niveau des parties du substrat localement déformées, situées en-deçà des zones (3) de sollicitation externe, et à leur croissance dans le reste du volume du substrat globalement déformé, en lieu et place des grains déformés.

Ce traitement thermique de recristallisation peut être réalisé par toute technique de recuit connue de l'homme du métier, et classiquement mise en oeuvre pour l'élaboration de cellules photovoltaïques, par exemple dans un four à passage.

Le traitement thermique de recristallisation est opéré à une température strictement supérieure à la température mise en oeuvre pour la déformation en étape (ii). De préférence, il est opéré à une température d'au moins 50 °C supérieure à la température mise en oeuvre en étape (ii), en particulier d'au moins 100 °C, voire d'au moins 150 °C supérieure à la température mise en oeuvre en étape (ii).

Il appartient aux connaissances de l'homme du métier d'adapter les conditions du recuit thermique, notamment en termes de durée et de température, pour obtenir le substrat recristallisé souhaité.

En particulier, le traitement thermique en étape (iv) peut être effectué à une température supérieure ou égale à 1 200 °C, en particulier comprise entre 1 250 et 1 400 °C et plus particulièrement d'environ 1 350 °C.

Selon un mode de réalisation particulier, cette étape de traitement thermique est opérée pendant une durée inférieure ou égale à 5 heures, en particulier comprise entre 30 minutes et 2 heures.

A l'issue de l'étape (iv) du procédé de l'invention, le substrat recristallisé peut notamment présenter un taux de recristallisation supérieur à 80 %, notamment supérieur à 90 %, en particulier supérieur à 99 %, voire sensiblement égal à 100 %.

Le taux de recristallisation du substrat peut être évalué par la technique de diffraction des électrons rétrodiffusés (technique EBSD pour « Electron Back Scattered Diffraction » en langue anglaise), à l'aide par exemple d'un microscope électronique à balayage (MEB).

Selon un mode de réalisation particulier, dans le cas où les étapes (ii) et (iii) de déformation sont toutes deux réalisées à chaud, les étapes (ii), (iii) et/ou (iv) peuvent avantageusement être réalisées dans un four à passage, permettant ainsi de favoriser des cadences élevées de production.

## SUBSTRAT RECRISTALLISE

Le substrat, appelé « substrat recristallisé », est susceptible d'être obtenu par le procédé décrit précédemment. Comme illustré en figure 2, le substrat recristallisé (10) présente, au niveau d'au moins l'une de ses faces, une succession de reliefs creux (4) espacés les uns des autres d'une distance (d), dans un plan vertical de coupe, supérieure ou égale à 20 $\mu$m, la profondeur d'un relief, mesurée selon une direction parallèle à l'épaisseur du substrat, étant d'au moins 5 $\mu$m.

Lesdits reliefs creux (4) peuvent plus particulièrement présenter une profondeur, mesurée selon une direction parallèle à l'épaisseur du substrat, comprise entre 20 et 100 $\mu$m.

De préférence, les reliefs creux (4) sont régulièrement espacés les uns des autres ; autrement dit, la distance (d) entre deux reliefs creux consécutifs est sensiblement la même pour l'ensemble des reliefs.

Ces reliefs creux correspondent aux déformations résiduelles du substrat liées à l'étape (iii) de déformation localisée du procédé selon l'invention.

Les reliefs creux peuvent par exemple correspondre aux marques produites en surface du substrat par les pointes d'un peigne mis en oeuvre en étape (iii) pour comprimer la surface du substrat.

Les reliefs creux d'un substrat recristallisé selon l'invention peuvent notamment présenter la forme de rainures s'étendant d'un bord à l'autre du substrat, selon sa longueur ou sa largeur.

De préférence, deux reliefs creux (4) consécutifs sont espacés d'une distance (d), dans un plan vertical de coupe, supérieure ou égale à 80 $\mu$m, en particulier d'au moins 100 $\mu$m, de préférence d'au moins 150 $\mu$m et plus préférentiellement comprise entre 200 et 2 000 $\mu$m.

Comme illustré en figure 2, la porosité, dite « porosité résiduelle », des parties du substrat (41) localisées en-deçà des reliefs creux (c'est-à-dire situées endessous des reliefs creux, dans une direction normale à la face présentant lesdits reliefs creux) est strictement inférieure à la porosité du reste du substrat (10).

Ces variations de porosité sont observables visuellement, par exemple à partir de clichés MEB.

Cette caractéristique peut être avantageusement utilisée pour distinguer un substrat recristallisé en mettant en oeuvre le procédé selon l'invention, de substrats qui ne seraient pas obtenus par un procédé conforme à l'invention.

Un substrat recristallisé selon le procédé de l'invention peut être plus particulièrement traversé sur son épaisseur par des joints de grains (50) localisés, dans un plan vertical de coupe, entre deux reliefs creux, en particulier sensiblement à équidistance de deux reliefs creux (4) consécutifs. Chaque cristallite du substrat recristallisé selon le procédé de l'invention s'étend sur toute l'épaisseur du substrat, comme représenté en figure 2.

Le substrat recristallisé présente une taille de cristallites supérieure ou égale à 20 $\mu$m. En particulier, la taille des cristallites peut être comprise entre 50 et 2 000 $\mu$m, notamment entre 100 et 300 $\mu$m. La taille moyenne des grains peut être mesurée par la technique des électrons rétro-diffusés (EBDS) à l'aide d'un microscope électronique à balayage (MEB).

De préférence, le rapport de la taille moyenne des cristallites du substrat recristallisé à l'issue de l'étape (iv), sur la taille moyenne des grains du substrat de départ de l'étape (i) est compris entre 2 et 10 000 en particulier compris entre 5 et 2 500 et plus particulièrement compris entre 50 et 1 000.

Comme évoqué précédemment, le substrat recristallisé est particulièrement bien adapté à sa mise en oeuvre comme substrat de base pour la formation par épitaxie de couches minces de silicium, pour une application photovoltaïque. Un dispositif photovoltaïque, en particulier une cellule photovoltaïque, comprenant un substrat de silicium recristallisé tel que décrit précédemment est susceptible d'être obtenu. Il appartient bien entendu aux connaissances générales de l'homme du métier de mettre en oeuvre les traitements adéquats classiques (dépôt de couches minces par épitaxie, formation d'une ou plusieurs métallisations, etc.) pour l'élaboration d'une cellule photovoltaïque à partir d'un substrat de silicium (10). L'invention va maintenant être décrite au moyen de l'exemple suivant, donné bien entendu à titre illustratif et non limitatif de l'invention.

## EXEMPLE

### (i) Substrat de départ

Le substrat utilisé est une plaquette de silicium présentant des faces de 1 cm$^2$ et une épaisseur de 400 $\mu$m. Elle est préalablement obtenue par frittage d'une poudre de particules de silicium à 1 350 °C pendant 3 heures, selon la technique de frittage naturel décrite dans le document WO 2012/049300 [2].

La plaquette de silicium présente une porosité, mesurée par densité Archimède, d'environ 14 %, et une taille de grains, mesurée par microscopie électronique à balayage (MEB), comprise entre 0,2 et 1 $\mu$m et une taille moyenne de grains de 0,6 $\mu$m.

### (ii) Déformation plastique globale

La plaquette est soumise à une déformation globale par laminage à chaud à 1150°C par passage entre deux rouleaux de carbure de silicium.

La déformation plastique, évaluée par mesure laser des dimensions géométriques de la pièce avant et après déformation, est d'environ 7 %.

La déformation est mesurée à l'aide de la convention suivante : $\mathscr{E}^p = 1 - h/h_0$ avec $h_0$ l'épaisseur initiale du substrat et h l'épaisseur du substrat déformé.

### (iii) Déformation plastique localisée

La plaquette est ensuite soumise à une déformation localisée par déplacement d'un peigne en carbure de silicium sur des zones de la face du substrat espacées d'environ 250 $\mu$m, à une température de 1 150 °C.

La déformation des parties du substrat localement déformées (parties situées en-deçà des reliefs creux produits par les pointes du peigne lors de l'opération de déformation localisée), évaluée par une mesure laser locale, est d'environ 40 %.

### (iv) Traitement thermique de recristallisation

La plaquette déformée est ensuite traitée thermiquement à 1 350 °C pendant 3 heures, et recristallise entièrement.

La recristallisation complète du silicium est confirmée par une observation EBSD (cliché de diffraction des électrons rétrodiffusés) de la plaquette, avant et après recristallisation.

### Résultat

La germination des cristallites et leur croissance à partir des parties du substrat déformées à 40 % est observée. La taille moyenne des cristallites formées autour des zones déformées, mesurée par microscopie électronique à balayage (MEB), est de 215 $\mu$m.

Références :

[1] WO 2004/093202 ;
[2] WO 2012/049300 ;
[3] Lebrun et al., J. Am. Ceramic. Soc., 1-9 (2012), DOI : 10.1111/j.1551-2916.2011.05052.x. ;
[4] Reber et al., Crystalline silicon thin film solar cells - recent results at Fraunhoffer ISE, Solar Energy, 77 (2004) 865-875;
[5] Schins et al.; J. Materials Science, 16 (1981), 3153-3160.

## Revendications

1. Procédé de préparation d'un substrat (10) de silicium présentant une taille moyenne de cristallites supérieure ou égale à 20 $\mu$m, comprenant au moins les étapes consistant en :

   (i) disposer d'un substrat (1) de silicium polycristallin dont la taille moyenne des grains est inférieure ou égale à 10 $\mu$m ;
   (ii) soumettre ledit substrat à une déformation plastique globale et homogène, à une température d'au moins 1 000 °C ;
   (iii) soumettre ledit substrat à une déformation plastique localisée en plusieurs zones (3) du substrat, dites zones de sollicitation externe, l'espacement (e) entre deux zones (3) consécutives étant d'au moins 20 $\mu$m ; la déformation locale du substrat étant strictement supérieure à la déformation globale opérée en étape (ii) ; l'étape (iii) pouvant être réalisée consécutivement ou simultanément à l'étape (ii) ; et
   (iv) soumettre le substrat obtenu à l'issue de l'étape (iii) à un traitement thermique de recristallisation en phase solide, à une température strictement supérieure à la température mise en oeuvre en étape (ii), pour obtenir ledit substrat (10) attendu.

2. Procédé selon la revendication 1, dans lequel ledit substrat (1) en étape (i) présente une taille moyenne de grains inférieure ou égale à 5 $\mu$m, en particulier comprise entre 0,1 et 2 $\mu$m.

3. Procédé selon la revendication 1 ou 2, dans lequel l'étape (ii) est opérée à une température comprise entre 1 100 et 1 200 °C, en particulier d'environ 1 150 °C.

4. Procédé selon l'une quelconque des revendications précédentes, dans lequel l'étape (ii) de déformation plastique globale est opérée par laminage à chaud, en particulier à l'aide de rouleaux de laminage en carbure de silicium (SiC) ou en nitrure de silicium (Si$_3$N$_4$), de préférence en carbure de silicium.

5. Procédé selon l'une quelconque des revendications précédentes, dans lequel la déformation plastique homogène du substrat à l'issue de l'étape (ii) est comprise entre 1 et 20 %, en particulier comprise entre 5 et 10 %.

6. Procédé selon l'une quelconque des revendications précédentes, dans lequel l'espacement (e) entre deux zones (3) consécutives est supérieur ou égal à 80 μm, en particulier supérieur ou égal à 100 μm, de préférence supérieur ou égal à 150 μm et plus préférentiellement compris entre 200 μm et 2 000 μm.

7. Procédé selon l'une quelconque des revendications précédentes, dans lequel l'étape (iii) de déformation plastique localisée est opérée à l'aide d'un peigne dont les pointes sont en un matériau de dureté Vickers supérieure ou égale à 250 MPa en particulier en carbure de silicium ou en nitrure de silicium, de préférence en carbure de silicium.

8. Procédé selon l'une quelconque des revendications 1 à 6, dans lequel l'étape (iii) de déformation plastique localisée est opérée par exposition desdites zones (3) à un rayonnement laser, en particulier à une ou plusieurs longueurs d'ondes supérieure(s) ou égale(s) à 100 nm, notamment allant de 400 à 5 000 μm.

9. Procédé selon l'une quelconque des revendications 1 à 8, dans lequel l'étape (iii) est opérée à une température supérieure ou égale à 1 000 °C, en particulier comprise entre 1 100 °C et 1 200 °C, l'étape (iii) de déformation localisée étant plus particulièrement opérée simultanément à l'étape (ii) de déformation globale, en particulier à l'aide d'un rouleau de laminoir dentelé.

10. Procédé selon l'une quelconque des revendications précédentes, dans lequel la déformation plastique locale du substrat à l'issue de l'étape (iii) est strictement supérieure à 20 %, en particulier comprise entre 30 et 60 %, et plus particulièrement d'environ 50 %.

11. Procédé selon l'une quelconque des revendications précédentes, dans lequel le traitement thermique de recristallisation en étape (iv) est opéré à une température d'au moins 50 °C supérieure à la température mise en oeuvre en étape (ii), en particulier d'au moins 100 °C, et plus particulièrement d'au moins 150 °C supérieure à la température mise en oeuvre en étape (ii).

**Patentansprüche**

1. Verfahren zur Herstellung eines Siliziumsubstrats (10) mit einer mittleren Kristallitgröße größer oder gleich 20 μm, umfassend mindestens die Schritte, die bestehen in:

(i) Bereitstellen eines Substrats (1) aus polykristallinem Silizium, bei dem die mittlere Korngröße kleiner oder gleich 10 μm ist;
(ii) Ausüben einer globalen und homogenen plastischen Verformung auf das Substrat bei einer Temperatur von wenigstens 1000 °C;
(iii) Ausüben einer lokalisierten plastischen Verformung auf das Substrat in mehreren Zonen (3) des Substrats, die als äußere Beanspruchungszonen bezeichnet werden, wobei der Abstand (e) zwischen zwei aufeinanderfolgenden Zonen (3) wenigstens 20 μm beträgt; wobei die lokale Deformation des Substrats streng größer ist als die globale Deformation in Schritt (ii); wobei der Schritt (iii) nach dem Schritt (ii) oder gleichzeitig mit diesem ausgeführt werden kann; und
(iv) Anwenden, auf das am Ende des Schrittes (iii) erhaltene Substrat, einer thermischen Rekristallisationsbehandlung in der festen Phase bei einer Temperatur die streng größer ist als die Temperatur bei der Ausführung des Schrittes (ii), um das genannte gewünschte Substrat (10) zu erhalten.

2. Verfahren nach Anspruch 1, bei dem das Substrat (1) in Schritt (i) eine mittlere Korngröße kleiner oder gleich 5 μm, insbesondere zwischen 0,1 und 2 μm hat.

3. Verfahren nach Anspruch 1 oder 2, bei dem der Schritt (ii) bei einer Temperatur zwischen 1100 und 1200 °C ausgeführt wird, insbesondere bei etwa 1150°C.

4. Verfahren nach einem der vorstehenden Ansprüche, bei dem der Schritt (ii) der globalen plastischen Verformung durch Heißlaminieren ausgeführt wird, insbesondere mit Hilfe einer Laminierwalze aus Siliziumkarbid (SiC) oder Siliziumnitrid (Si$_3$N$_4$), vorzugsweise Siliciumkarbid.

5. Verfahren nach einem der vorstehenden Ansprüche, bei dem die homogene plastische Verformung des Substrats am Ende des Schrittes (ii) zwischen 1 und 20 %, insbesondere zwischen 5 und 10 % beträgt.

6. Verfahren nach einem der vorstehenden Ansprüche, bei dem der Abstand (i) zwischen zwei aufeinanderfolgenden Zonen (3) größer oder gleich 80 μm ist, insbesondere größer oder gleich 100 μm, vorzugs-

weise größer oder gleich 150 μm und besonders bevorzugt zwischen 200 μm und 2000 μm.

**7.** Verfahren nach einem der vorstehenden Ansprüche, bei dem der Schritt (iii) der lokalisierten plastischen Verformung mit Hilfe eines Kammes ausgeführt wird, dessen Zinken aus einem Material mit einer Vickers-Härte größer oder gleich 250 MPa gebildet sind, insbesondere aus Siliziumkarbid oder Siliziumnitrid, vorzugsweise Siliciumkarbid.

**8.** Verfahren nach einem der Ansprüche 1 bis 6, bei dem der Schritt (iii) der lokalisierten plastischen Verformung ausgeführt wird, in dem die genannten Zonen (3) einer Laserbestrahlung ausgesetzt werden, insbesondere bei einer oder mehreren Wellenlängen größer oder gleich 100 nm, insbesondere von 400 bis 5000 nm.

**9.** Verfahren nach einem der Ansprüche 1 bis 8, bei dem der Schritt (iii) bei einer Temperatur größer oder gleich 1000 °C ausgeführt wird, insbesondere zwischen 1100°C und 1200 °C, der Schritt (iii) der lokalisierten Verformung insbesondere gleichzeitig mit dem Schritt (ii) der globalen Verformung ausgeführt wird, insbesondere mit Hilfe einer gezahnten Laminierwalze.

**10.** Verfahren nach einem der vorstehenden Ansprüche, bei dem die lokale plastische Verformung des Substrats am Ende des Schrittes (iii) streng größer ist als 20 %, insbesondere zwischen 30 und 60 % und weiter insbesondere etwa 50 %.

**11.** Verfahren nach einem der vorstehenden Ansprüche, bei dem die thermische Rekristallisationsbehandlung in Schritt (iv) bei einer Temperatur ausgeführt wird, die wenigstens 50 °C höher ist als die Temperatur in Schritt (ii), insbesondere wenigstens 100 °C, weiter insbesondere wenigstens 150 °C höher als die Temperatur in Schritt (ii).

**Claims**

**1.** A process for preparing a silicon substrate (10) having an average crystallite size larger than or equal to 20 μm, comprising at least the steps consisting in:

(i) providing a polycrystalline silicon substrate (1) the average grain size of which is lower or equal to 10 μm;
(ii) subjecting said substrate to an overall and uniform plastic deformation at a temperature of at least 1000°C;
(iii) subjecting said substrate to a plastic deformation localized in a plurality of substrate zones (3) referred to as zones of external stress, the spacing (e) between two consecutive zones (3) being at least 20 μm, the local deformation of the substrate being strictly greater than the overall deformation carried out in step (ii), step (iii) possibly being carried out consecutively to or at the same time as step (ii); and
(iv) subjecting the substrate obtained at the end of step (iii) to a solid-phase recrystallization heat treatment, at a temperature strictly higher than the temperature implemented in step (ii), in order to obtain said expected substrate (10).

**2.** The process as claimed in claim 1, in which said substrate (1) in step (i) has an average grain size of 5 μm or less, and in particular comprised between 0.1 and 2 μm.

**3.** The process as claimed in claim 1 or 2, in which step (ii) is carried out at a temperature comprised between 1100 and 1200°C, and in particular of about 1150°C.

**4.** The process as claimed in any one of the preceding claims, in which the step (ii) of overall plastic deformation is carried out by hot rolling, in particular using rolling rolls made of silicon carbide (SiC) or silicon nitride ($Si_3N_4$) and preferably of silicon carbide.

**5.** The process as claimed in any one of the preceding claims, in which the uniform plastic deformation of the substrate at the end of step (ii) is comprised between 1 and 20% and in particular comprised between 5 and 10%.

**6.** The process as claimed in any one of the preceding claims, in which the spacing (e) between two consecutive zones (3) is larger than or equal to 80 μm, in particular larger than or equal to 100 μm, preferably larger than or equal to 150 μm, and more preferably comprised between 200 μm and 2000 μm.

**7.** The process as claimed in any one of the preceding claims, in which the step (iii) of localized plastic deformation is carried out using a comb the tips of which are made of a material of Vickers hardness higher than or equal to 250 MPa, and in particular of silicon carbide or silicon nitride, and preferably of silicon carbide.

**8.** The process as claimed in any one of claims 1 to 6, in which the step (iii) of localized plastic deformation is carried out by exposing said zones (3) to laser radiation, in particular at one or more wavelengths longer than or equal to 100 nm and especially ranging from 400 to 5000 nm.

**9.** The process as claimed in any one of claims 1 to 8, in which step (iii) is carried out at a temperature higher than or equal to 1000°C and in particular comprised between 1100°C and 1200°C, the step (iii) of localized deformation being more particularly carried out at the same time as the step (ii) of overall deformation, in particular using a toothed roller roll.

10. The process as claimed in any one of the preceding claims, in which the local plastic deformation of the substrate at the end of step (iii) is strictly larger than 20%, in particular comprised between 30 and 60%, and more particularly about 50%.

11. The process as claimed in any one of the preceding claims, in which the recrystallization heat treatment in step (iv) is carried out at a temperature at least 50°C above the temperature implemented in step (ii) and in particular at least 100°C and more particularly at least 150°C above the temperature implemented in step (ii).

Fig. 1

Fig. 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012049300 A
- WO 2004093202 A

**Littérature non-brevet citée dans la description**

- **LEBRUN et al.** *J. Am. Ceramic. Soc.,* 2012, vol. 1-9
- **REBER et al.** *Crystalline silicon thin film solar cells - recent results at Fraunhoffer ISE, Solar Energy,* 2004, vol. 77, 865-875
- **SCHINS et al.** *J. Materials Science,* 1981, vol. 16, 3153-3160